# FASCICULE DE BREVET EUROPEEN

(11) **EP 1 217 093 B1**
(45) Date de publication et mention de la délivrance du brevet: **09.02.2011**
(21) Numéro de dépôt: 01403282.5
(22) Date de dépôt: 18.12.2001
(51) Int. Cl.: C23C 16/04

(54) **Densification de substrats poreux creux par infiltration chimique en phase vapeur**
Verdichtung eines porösen Substrats durch chemische Damfphaseinfiltration
Densification of porous substrate by vapor phase chemical infiltration

(30) Priorité: 19.12.2000 FR 0016615
(43) Date de publication de la demande: 26.06.2002
(73) Titulaire: Snecma Propulsion Solide, 33187 Le Haillan Cedex (FR)
(72) Inventeur: Delperier, Bernard, 33127 Martignas sur Jalles (FR); Domblides, Jean-Luc, 33520 Bruges (FR); Richard, Jean-Philippe, 33320 Le Taillan Medoc (FR); Delaurens, Pierre, 33600 Pessac (FR)
(74) Mandataire: Joly, Jean-Jacques

(56) Documents cités:
- FR-A- 2 801 304
- US-A- 4 609 562
- US-A- 5 904 957
- PATENT ABSTRACTS OF JAPAN vol. 1995, no. 06, 31 juillet 1995 (1995-07-31) & JP 07 082058 A (NISSAN MOTOR CO LTD), 28 mars 1995 (1995-03-28)

## Description

### Arrière-plan de l'invention

L'invention concerne la densification de substrats poreux creux par infiltration chimique en phase vapeur, plus particulièrement en mode isobare, c'est-à-dire sans gradient de pression entre des faces des substrats.

Un domaine particulier d'application de l'invention est la réalisation de pièces creuses en matériau composite comprenant un substrat poreux densifié par une matrice, notamment de pièces creuses en matériau composite thermostructural.

Par substrat poreux creux, on entend ici un substrat ayant une forme creuse avec une surface interne concave pleine, c'est-à-dire exempte de trous, excepté le caractère poreux du substrat. Des exemples de formes creuses sont des formes de calottes sphériques, des formes cylindriques ou cylindro-coniques fermées à une extrémité, des formes de récipients ou de bols, des formes de coiffes, non nécessairement axisymétriques. Des exemples de pièces creuses obtenues par densification de tels substrats sont des récipients pour l'industrie chimique ou métallurgique, tels que des creusets ou des bols de support de creusets, ou des corps de protection de véhicules spatiaux, tels que des nez formant boucliers thermiques.

Par matériau composite thermostructural, on entend ici un matériau composite qui, à la fois, présente des bonnes propriétés mécaniques, pour constituer des éléments de structure, et a la capacité de conserver ces propriétés aux températures élevées. Des exemples de matériaux composites thermostructuraux sont les matériaux composites carbone/carbone (C/C) comprenant un substrat poreux en fibres de carbone densifié par une matrice en carbone, et les matériaux composites à matrice céramique (CMC) comportant un substrat poreux réfractaire, par exemple en fibres de carbone ou de céramique, densifié par une matrice en céramique.

La densification de substrats poreux par infiltration chimique en phase vapeur isobare est un processus bien connu. Les substrats à densifier sont placés dans une enceinte et une phase gazeuse réactive est admise dans l'enceinte où règnent des conditions de température et de pression contrôlées telles que la phase gazeuse diffuse au sein de la porosité des substrats et y forme un dépôt solide constitutif de la matrice du matériau composite par décomposition d'un précurseur gazeux ou réaction entre plusieurs précurseurs gazeux contenus dans la phase gazeuse. Dans le cas par exemple d'une matrice en carbone, le précurseur gazeux est généralement un alcane, un alkyle ou un alcène, tel que du propane ou du méthane ou un mélange des deux. Dans le cas par exemple d'une matrice céramique en carbure de silicium, le précurseur gazeux est du méthyltrichlorosilane.

Généralement, la phase gazeuse réactive est admise à une extrémité de l'enceinte tandis que les effluents gazeux comprenant le résidu de phase gazeuse et des produits de réaction éventuels sont extraits à une autre extrémité. L'admission est avantageusement effectuée à travers une zone de préchauffage permettant d'amener la phase gazeuse à une température voisine de celle des substrats à densifier.

Plusieurs substrats peuvent être densifiés simultanément dans une même enceinte, en étant disposés de façon à être tous exposés au flux de phase gazeuse réactive admise dans l'enceinte. Le brevet US 5 904 957 de la déposante montre à cet effet une disposition particulière de substrats identiques en piles annulaires. La phase gazeuse admise est dirigée vers l'intérieur (ou l'extérieur) des piles et s'écoule à travers les substrats et des intervalles entre ceux-ci pour être reprise à l'extérieur (ou à l'intérieur) des piles.

Lorsque les substrats à densifier ont une forme creuse telle que définie plus haut, avec des parties concaves relativement profondes, et notamment lorsqu'ils sont de dimensions assez grandes, des défauts ont été observés par les inventeurs après densification par infiltration chimique en phase vapeur. Ces défauts consistent en des variations de microstructure du matériau de la matrice entre différentes parties des pièces densifiées et en la formation de suies ou d'excroissances indésirables sur les substrats.

Ces défauts pouvant être attribués à une maturation excessive de la phase gazeuse, c'est-à-dire à un temps de séjour dans l'enceinte trop long conduisant à un vieillissement de la phase gazeuse et à une altération de ses propriétés, il a été essayé d'y remédier en augmentant le débit par accroissement des capacités de pompage des effluents gazeux hors de l'enceinte. Cela n'a toutefois pas permis d'éliminer complètement les défauts, tout en renchérissant sensiblement les coûts en raison notamment de l'augmentation de la consommation en phase gazeuse réactive.

### Objets et résumé de l'invention

L'invention a pour but de fournir un procédé qui ne présente pas de tels inconvénients, c'est-à-dire un procédé permettant une densification relativement homogène, et exempte de défauts, de substrats de forme creuse, même de grandes dimensions.

Ce but est atteint grâce à un procédé tel que défini par la revendication 1.

Avantageusement, le flux de phase gazeuse réactive admise dans l'enceinte est réparti vers chaque face du ou de chaque substrat disposé dans l'enceinte. De préférence, la fraction du flux total de phase gazeuse réactive parcourant une face du ou de chaque substrat disposé dans l'enceinte est d'au moins 5 %, ou mieux encore, 10 %.

Les inventeurs ont observé que, en guidant une fraction du flux de phase gazeuse dans l'enceinte jusqu'à l'intérieur des substrats, une densification homogène est obtenue, sans formation de suies ou excroissances parasites, y compris dans les zones situées le plus au fond des formes creuses. Cela peut s'expliquer par le fait que le guidage du flux force la phase gazeuse à s'écouler le long de la totalité des faces concaves internes des substrats, sans former des poches de stagnation ou zones tourbillonnaires dans lesquelles une maturation excessive de la phase gazeuse pourrait se produire.

Le guidage d'une partie du flux de phase gazeuse peut être assuré par une partie de paroi cylindrique qui s'étend jusqu'au voisinage du fond du ou de chaque substrat.

Avantageusement, plusieurs substrats de forme creuse peuvent être densifiés simultanément dans l'enceinte en étant disposés de façon alignée avec la direction générale d'écoulement du flux de phase gazeuse à travers l'enceinte. Le flux de phase gazeuse admise dans l'enceinte est alors réparti de façon appropriée pour alimenter chaque face des substrats par une fraction de ce flux.

L'invention a aussi pour but de fournir une installation de densification par infiltration chimique en phase vapeur qui permette la mise en oeuvre du procédé ci-dessus défini en étant adaptée à la densification de substrats de forme creuse.

Ce but est atteint avec une installation telle que définie par la revendication 8.

Les moyens de guidage de flux peuvent comporter une partie de paroi cylindrique ou un corps présentant une pluralité de passages traversants, la partie de paroi ou le corps étant disposé de manière à pénétrer au moins en partie dans ledit volume du substrat.

Les moyens de répartition de flux peuvent comprendre un ou plusieurs plateaux qui sont disposés transversalement dans l'enceinte et qui définissent des passages de répartition de flux formés par des ouvertures réalisées à travers les plateaux et des espaces ménagés entre les plateaux et une paroi latérale de l'enceinte.

### Brève description des dessins

L'invention sera mieux comprise à la lecture de la description faite ci-après, à titre indicatif mais non limitatif, en référence aux dessins annexés sur lesquels :
- la figure 1 est une vue très schématique partielle en élévation et en coupe d'une installation d'infiltration chimique en phase vapeur selon un premier mode de mise en oeuvre de l'invention ;
- la figure 2 est une demi-vue en coupe de dessus selon le plan II-II de la figure 1 ;
- la figure 3 est une vue très schématique partielle en élévation et en coupe d'une installation d'infiltration chimique en phase vapeur selon un deuxième mode de mise en oeuvre de l'invention ;
- la figure 4 est une demi-vue en coupe de dessus selon le plan IV-IV de la figure 3 ;
- la figure 5 est une vue très schématique partielle en élévation et en coupe selon les plans V-V de la figure 6 d'une installation d'infiltration chimique en phase vapeur selon un troisième mode de mise en oeuvre de l'invention ;
- la figure 6 est une vue en coupe de dessus selon le plan VI-VI de la figure 5 ;
- la figure 7 est une vue très schématique partielle en élévation et en coupe d'une installation d'infiltration chimique en phase vapeur selon un quatrième mode de mise en oeuvre de l'invention ;
- la figure 8 est une vue partielle en coupe montrant une variante de réalisation d'un outillage de guidage du flux de phase gazeuse réactive vers la face interne concave d'un substrat ;
- la figure 9 est une photographie montrant l'aspect général de surface d'une face concave de substrat densifié avec le procédé conforme à l'invention ;
- la figure 10 est une photographie obtenue en microscopie optique montrant une fraction de surface de la face concave du substrat densifié de la figure 9 ;
- la figure 11 est une vue très schématique d'une installation d'infiltration chimique en phase vapeur selon l'art antérieur ; et
- les figures 12 et 13 sont des photographies obtenues en microscopie optique montrant l'état de surface d'échantillons, après densification au moyen de l'installation de la figure 11.

### Description détaillée de modes de réalisation de l'invention

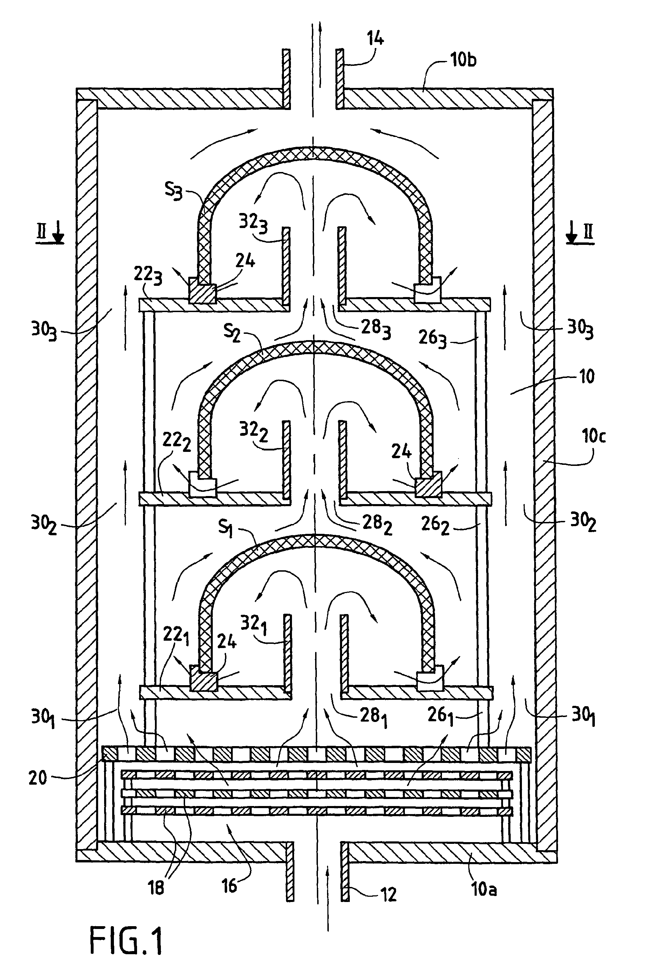

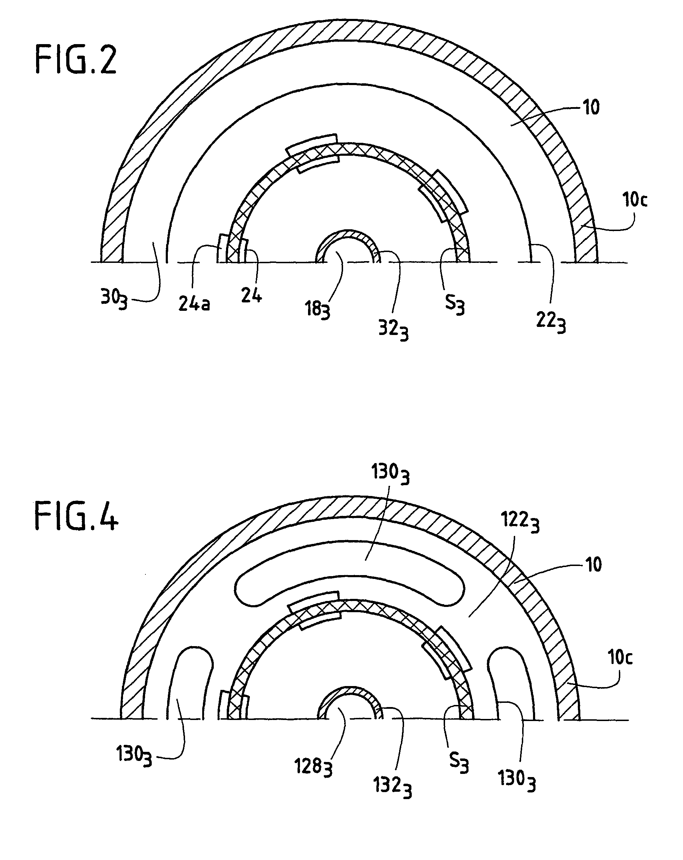

Les figures 1 et 2 montrent schématiquement une enceinte 10 constituant une chambre de réaction d'une installation d'infiltration chimique en phase vapeur.

L'enceinte 10 a, dans l'exemple illustré, une forme générale cylindrique d'axe vertical. Une phase gazeuse réactive est introduite dans l'enceinte par une canalisation 12 qui débouche par exemple au centre de la paroi de fond 10a de l'enceinte 10. Les effluents gazeux sont extraits de l'enceinte par une conduite 14 qui débouche au centre de la paroi supérieure 10b formant couvercle opposé au fond 10a. La conduite 14 est reliée à un dispositif de pompage (non représenté).

Dans la partie inférieure de l'enceinte, la phase gazeuse traverse une zone de préchauffage 16 constituée par exemple de plateaux perforés horizontaux 18 qui sont disposés les uns au-dessus des autres. Les plateaux 18 sont supportés par le fond 10a de l'enceinte au moyen de pieds et entretoises.

La zone de préchauffage est séparée de la chambre de réaction proprement dite par un plateau diffuseur horizontal 20 qui occupe sensiblement toute la section de l'enceinte 10. Le plateau diffuseur 20 est perforé et repose sur le fond 10a de l'enceinte par l'intermédiaire de pieds.

Les éléments ci-dessus de la zone de préchauffage sont en matériau réfractaire, par exemple en graphite.

Le chauffage à l'intérieur de l'enceinte est produit par un suscepteur (ou induit) en graphite couplé électromagnétiquement avec un inducteur (non représenté) situé à l'extérieur de l'enceinte. Le suscepteur constitue la paroi latérale 10c de l'enceinte 10. Le fond 10a et le couvercle 10b sont également en graphite.

Une installation telle que brièvement décrite ci-avant est d'un type bien connu.

Dans l'exemple illustré par la figure 1, plusieurs substrats de forme creuse sont disposés dans l'enceinte 10 pour être densifiés simultanément, en l'espèce trois substrats S₁, S₂, S₃. Les substrats représentés ont une forme de bol. Il peut s'agir par exemple d'une préforme de bol en matériau composite C/C destiné à recevoir un creuset contenant du silicium liquide dans une installation de tirage de lingots de silicium monocristallin par le procédé Czochralski, ou procédé "CZ". De tels bols peuvent avoir un diamètre atteignant, voire dépassant 850 mm. Le substrat ou préforme du bol est réalisé en fibres de carbone, par bobinage filamentaire ou drapage de strates fibreuses. Bien entendu, l'invention n'est pas limitée à la densification de tels substrats et vise la densification de tous substrats de forme creuse tels que définis en tête de la présente description.

Les substrats sont disposés l'un au-dessus de l'autre, en étant alignés dans la direction générale verticale d'écoulement du flux de phase gazeuse dans l'enceinte, avec leurs faces creuses concaves tournées vers le bas.

Chaque substrat S₁, S₂, S₃ repose sur un plateau support respectif 22₁, 22₂, 22₃ avec interposition de cales 24 entre le bord des substrats et les faces supérieures des plateaux. Le plateau support 22₁ repose par des entretoises 26₁ sur le plateau diffuseur 20, tandis que les plateaux 22₂ et 22₃ reposent sur les plateaux 22₁ et 22₂ par l'intermédiaire d'entretoises 26₂, 26₃.

Les cales 24 ménagent entre elles des intervalles permettant la circulation de gaz. Elles peuvent avoir une forme générale de secteur d'anneau et s'engager par leur base dans une rainure annulaire formée dans la face supérieure du plateau support. Chaque cale 24 peut présenter un rebord externe annulaire 24a sur lequel le rebord du substrat vient en appui par son contour extérieur. Les cales 24 agissent alors comme conformateurs en empêchant une déformation par expansion des substrats. Les cales 24 pourraient également comporter un rebord interne.

Les plateaux supports, les cales et les entretoises supportant les plateaux sont en un matériau réfractaire, par exemple un métal réfractaire ou du graphite.

Les plateaux supports 22₁, 22₂ et 22₃ ont également une fonction de répartiteurs du flux de la phase gazeuse admise dans l'enceinte et issue de la zone de préchauffage. A cet effet, les plateaux sont en un matériau étanche au gaz, présentent un orifice respectivement 28₁, 28₂, 28₃ en leur centre et ménagent à leur périphérie un espace annulaire respectif 30₁, 30₂, 30₃ avec la paroi latérale 10c de l'enceinte.

Les orifices 28₁, 28₂, 28₃ et les passages définis par les espaces annulaires 30₁, 30₂, 30₃ répartissent le flux de la phase gazeuse de sorte qu'une fraction de la phase gazeuse fraîche admise dans l'enceinte parvienne à chaque emplacement d'un substrat dans l'enceinte et sur chaque face d'un substrat disposé en cet emplacement. Cette fraction est d'au moins 5 %, de préférence au moins 10 % en volume.

Dans l'exemple illustré, chacune des faces interne et externe des substrats S₁, S₂ et S₃ reçoit par conséquent de préférence au moins 10 %, et mieux encore environ 1/6^{ème} du flux de phase gazeuse fraîche admise dans l'enceinte. Le passage 30₁ reçoit le complément du flux total de phase gazeuse admise par rapport à ce qui est reçu par la face interne du substrat S₁ via l'orifice 28₁. Le passage 30₂ reçoit le complément du flux de phase gazeuse admise ayant traversé le passage 30₁, par rapport à ce qui est reçu par la face externe du substrat S₁ et ce qui est reçu par la face interne du substrat S₂ via l'orifice 28₂. Le passage 30₃ reçoit le complément du flux de phase gazeuse admise ayant traversé le passage 30₂, par rapport à ce qui est reçu par la face externe du substrat S₂ et ce qui est reçu par la face interne du substrat S₃ via l'orifice 28₃. Cette fraction restante du flux de phase gazeuse admise passant à travers le passage 30₃ alimente la face externe du substrat S₃.

Chaque fraction de flux de phase gazeuse passant à travers un orifice 28₁, 28₂, 28₃ est guidée vers la face interne du fond du substrat correspondant au moyen d'une paroi de guidage respective 32₁, 32₂, 32₃, prévue à chaque emplacement d'un substrat dans l'enceinte, et constituant un outillage de guidage de flux de phase gazeuse pour le substrat associé.

Chacune de ces parois de guidage a une forme cylindrique, ou de tronçon de canalisation, qui se raccorde à un orifice respectif 28₁, 28₂, 28₃ et fait saillie au-dessus du plateau de support correspondant, à l'intérieur du volume délimité par le substrat. Chaque paroi de guidage amène ainsi une fraction de flux directement au voisinage de la région de fond du substrat correspondant. Chaque paroi de guidage s'interrompt à une distance de la surface interne du substrat correspondant telle qu'un intervalle annulaire est ménagé avec celle-ci offrant une section de passage au moins égale à celle de l'orifice formé dans le plateau de support.

Les parois de guidage sont en un matériau réfractaire de préférence étanche aux gaz, par exemple en un métal réfractaire ou en graphite, ou encore en feuilles de pyrographite, telles que produites sous la dénomination "SIGRAFLEX® " par la société allemande SIGRI GmbH.

Grâce aux parois de guidage 32₁, 32₂, 32₃, on force une fraction du flux de phase gazeuse admise à lécher intégralement les faces internes des substrats S₁, S₂, S₃ et à s'écouler le long de celles-ci sans laisser de volume mort et sans créer de tourbillons. On peut ainsi garantir que le temps de séjour de la phase gazeuse reste en tout point inférieur à une valeur limite au-delà de laquelle la maturation de la phase gazeuse peut devenir excessive et entraîner la formation de dépôts parasites. En règle générale, le temps de séjour total de la phase gazeuse dans l'enceinte, c'est-à-dire le temps s'écoulant entre son admission et son évacuation doit rester limité. Dans le cas d'une matrice carbone, le temps de séjour est par exemple généralement contrôlé pour rester inférieur à 2 s, typiquement compris entre 1 s et 1,5 s.

Les parties résiduelles des fractions de flux de phase gazeuse ayant parcouru les faces internes des substrats sont évacuées après avoir traversé les espaces entre les cales 24. L'ensemble des effluents gazeux est réuni à la partie supérieure de l'enceinte pour être évacué par la conduite 14.

Le processus d'infiltration chimique en phase vapeur est de type isobare, c'est-à-dire sans gradient de pression entre les faces internes et externes des substrats.

Bien que l'on ait envisagé la densification simultanée de trois substrats, le nombre de substrats présents dans l'enceinte pourra bien sûr être différent de trois, voire unique, tout en ménageant la possibilité de répartir le flux de phase gazeuse pour qu'une fraction significative alimente chaque face des substrats.

On pourra aussi densifier plusieurs ensembles de substrats disposés côte à côté dans une enceinte, chaque ensemble comprenant un ou plusieurs substrats alignés dans la direction générale d'écoulement de la phase gazeuse. Plusieurs orifices d'admission de la phase gazeuse dans l'enceinte, plusieurs orifices d'évacuation d'effluents gazeux hors de l'enceinte et plusieurs zones de préchauffage pourront alors être prévus, chacun au droit d'un ensemble de substrats et de plateaux de support.

En outre, des substrats de formes creuses différentes ou de différentes dimensions pourront être densifiés simultanément dans une même enceinte, en adaptant éventuellement les formes et dimensions des moyens de guidage de flux vers l'intérieur des substrats. On pourra aussi disposer dans l'enceinte d'autres substrats de forme non creuse, ou de forme creuse non prononcée qui ne nécessitent pas de moyens spécifiques de guidage de flux.

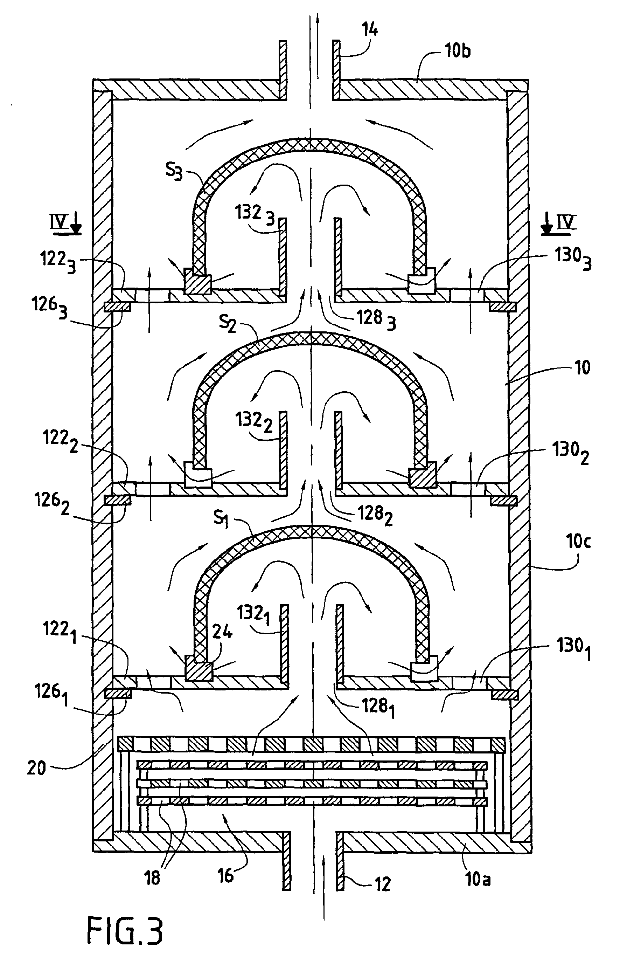

Les figures 3 et 4 illustrent une autre variante de mise en oeuvre de l'invention. L'installation des figures 3 et 4 se distingue de celle des figures 1 et 2 en ce que les plateaux supports 122₁, 122₂, 122₃ ne reposent pas sur des entretoises mais sur des taquets ou pions 126₁, 126₂, 126₃ engagés dans la paroi latérale 10c de l'enceinte, à la manière d'étagères.

Les plateaux supports peuvent alors occuper la quasi-totalité de la section de l'enceinte 10.

Comme dans le mode de réalisation des figures 1 et 2, chaque plateau support présente un orifice central 128₁, 128₂, 128₃ auquel se raccorde un outillage de guidage de flux de phase gazeuse réactive, formé par une paroi cylindrique 132₁, 132₂, 132₃.

Des lumières 130₁, 130₂, 130₃ sont pratiquées dans les plateaux le long d'une zone annulaire de ceux-ci, à l'extérieur de l'aplomb des bords des substrats S₁, S₂, S₃, afin d'offrir des passages directs à des fractions de flux de phase gazeuse admis dans l'enceinte à travers les plans des plateaux, de la même manière que les passages 30₁, 30₂, 30₃ des figures 1 et 2.

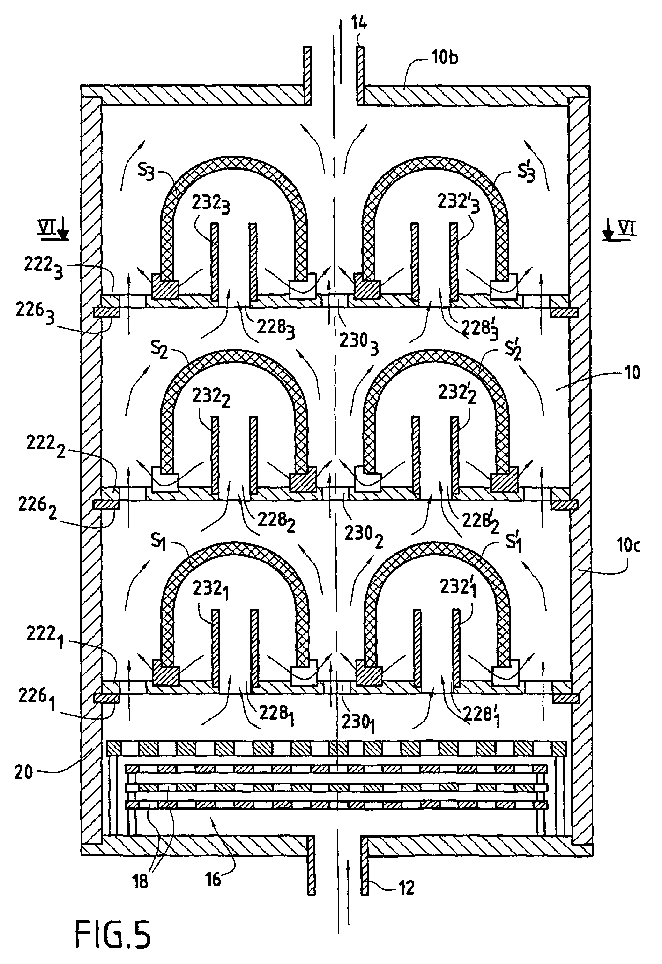

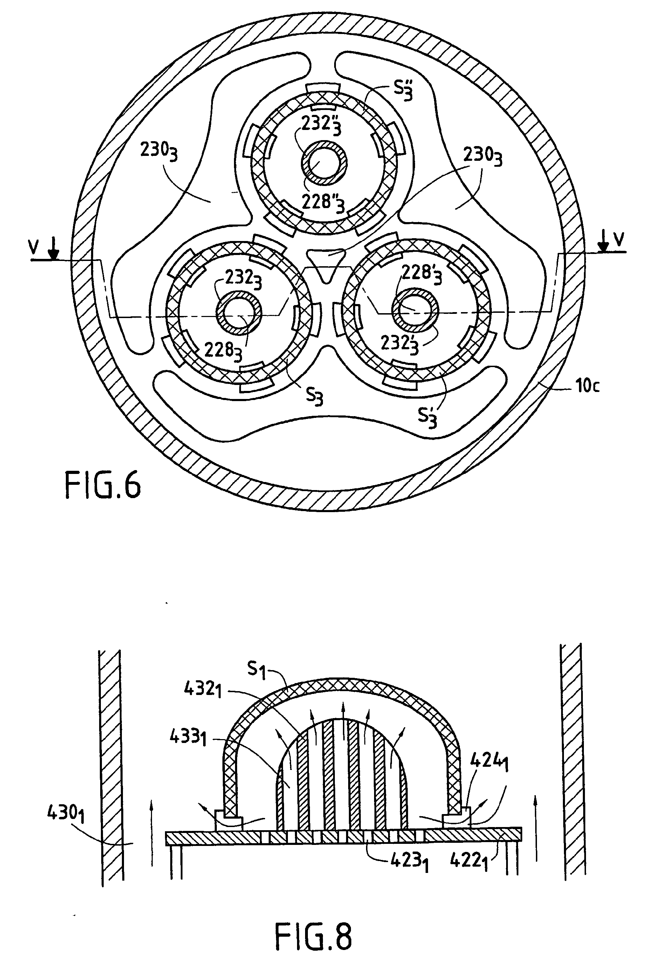

Les figures 5 et 6 illustrent encore une autre variante de mise en oeuvre de l'invention. L'installation des figures 5 et 6 se distingue de celle des figures 3 et 4 en ce que les plateaux supports 222₁, 222₂, 222₃, qui reposent sur des taquets 226₁, 226₂, 226₃, portent chacun une pluralité de substrats, en l'espèce trois substrats tels que les substrats S₃, S'₃, S"₃ pour le plateau 222₃.

Chaque plateau, par exemple le plateau 222₃, comporte plusieurs orifices 228₃, 228'₃ et 228"₃ pour diriger une fraction de flux de phase gazeuse vers chaque face concave interne des substrats supportés par le plateau. Un outillage de guidage formé par une paroi de guidage cylindrique respective 232₃, 232'₃, 232"₃ se raccorde à chaque orifice et fait projection à l'intérieur du volume délimité par le substrat correspondant afin de guider la fraction de flux jusqu'au voisinage du fond du substrat. Des lumières 230₃ sont formées dans le plateau 222₃ autour des emplacements des substrats S₃, S'₃, S"₃ afin de permettre un franchissement direct du plan du plateau 222₃ par une partie du flux de phase gazeuse admise dans l'enceinte, autour de chaque substrat.

Les plateaux 222₁ et 222₂ sont réalisés de la même façon que le plateau 222₃ avec des orifices tels que 228₁, 228'₁, 228₂ et 228'₂ auxquels se raccordent des parois de guidage 232₁, 232'₁, et 232₂, 232'₂, et avec des lumières 230₁ et 230₂.

Les dimensions des orifices et lumières formés dans les plateaux support sont choisies pour assurer la répartition désirée du flux de phase gazeuse fraîche admise dans l'enceinte 10 vers les faces des substrats.

Plusieurs conduites d'évacuation d'effluents gazeux 214, 214', 214" sont de préférence prévues qui sont réunies à l'extérieur de l'enceinte et s'ouvrent dans celles-ci en regard des sommets des substrats disposés sur le plateau supérieur, afin d'assurer un parcours complet des faces extérieures de ces substrats par du flux de phase gazeuse.

Dans les modes de réalisation décrits ci-avant, les substrats sont disposés dans l'enceinte d'infiltration avec leurs faces internes concaves dirigées vers le bas, c'est-à-dire dirigées à l'encontre du sens général d'écoulement du flux de phase gazeuse réactive dans l'enceinte.

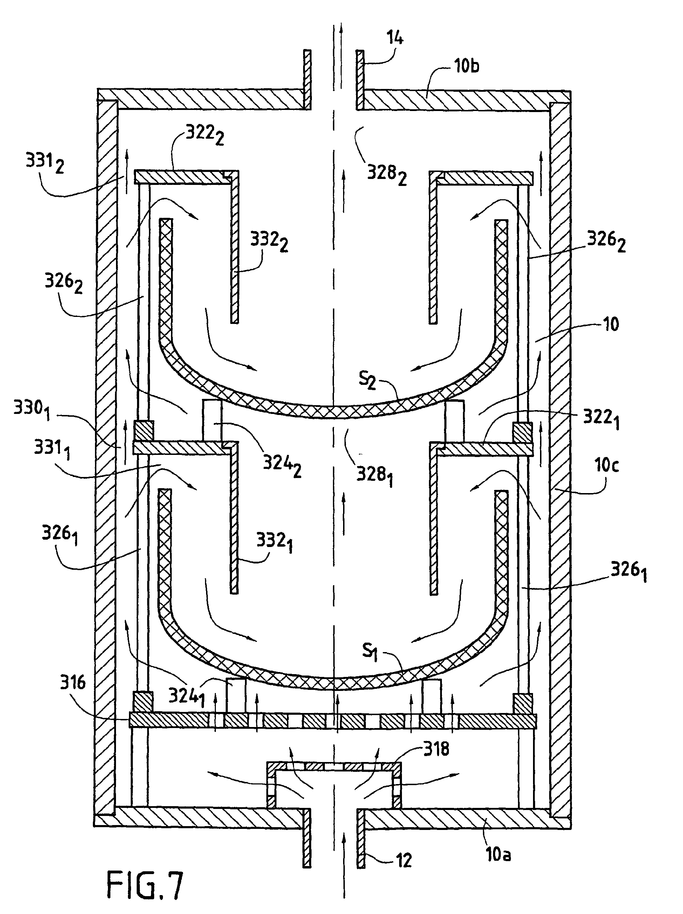

Une disposition inversée des substrats pourra être adoptée, comme montré par la figure 7.

Le mode de réalisation de la figure 7 se distingue de celui de la figure 1, notamment en ce que les substrats S₁, S₂ sont disposés dans l'enceinte 10 avec leurs faces internes concaves dirigées vers le haut.

Chaque substrat S₁, S₂ repose par la face externe de son fond sur une pluralité de (au moins trois) cales ou plots 324₁, 324₂. Les plots 324₁ sont supportés par un plateau 316 assurant des fonctions de préchauffage et diffusion de la phase gazeuse admise dans l'enceinte par la canalisation 12 débouchant au fond de l'enceinte, l'orifice d'entrée de la phase gazeuse étant surmonté d'un chapeau 318 de répartition de flux.

Les plots 324₂ sont fixés sur un plateau support respectif 322₁ qui repose sur le plateau diffuseur 316 par l'intermédiaire d'entretoises 326₂.

Le plateau support 322₁ présente une large ouverture centrale 328₁ tout en ménageant à sa périphérie un espace annulaire 330₁ avec la paroi latérale 10c de l'enceinte.

En outre, le plateau 322₁ surmonte le substrat S₁ en ménageant un espace annulaire 331₁ avec le bord supérieur du substrat.

Un plateau supérieur 322₂ supporté par des entretoises 326₂ est disposé au-dessus du substrat S₂ de la même manière que le plateau 322₁ par rapport au substrat S₁. Le plateau 322₂ présente une large ouverture centrale 328₂ et ménage un espace annulaire 330₂ avec la paroi latérale de l'enceinte et un espace annulaire 331₂ avec le bord supérieur du substrat S₂.

Le flux de phase gazeuse réactive admise dans l'enceinte est réparti à travers les espaces 330₁, 330₂ et 331₂ de manière à ce qu'une fraction de ce flux alimente chaque face des substrats.

La fraction de flux passant à travers les espaces 331₁, 331₂ est guidée vers la face interne concave des substrats S₁, S₂ au moyen d'outillages formés par des parois de guidage respectives 332₁, 332₂. Les parois de guidage ont par exemple une forme de cylindre, ou de tronçon de canalisation, qui sont supportées par les plateaux 322₁, 322₂ en se raccordant à leur partie supérieure aux bords des ouvertures 328₁, 328₂. Chaque paroi de guidage pénètre sur une certaine distance dans la partie interne d'un substrat respectif pour amener le flux admis à la périphérie à se diriger vers le fond du substrat avant de s'écouler vers le haut à travers la canalisation définie par la paroi de guidage (voir flèches sur la figure 7).

La phase gazeuse résiduelle s'écoulant à travers l'ouverture 328₂ du plateau supérieure est évacuée par la conduite 24 qui débouche à travers le couvercle 10b de l'enceinte.

Les parois de guidage 332₁, 332₂ forcent ainsi une fraction du flux de phase gazeuse réactive admise à lécher les faces internes des substrats S₁, S₂ et à s'écouler le long de celles-ci sans laisser de volume mort et sans créer de tourbillons.

Bien que le mode de réalisation de la figure 7 montre seulement deux emplacements de substrats, le nombre de ces emplacements pourra bien entendu être supérieur à deux, en disposant plus de deux substrats les uns au-dessus des autres ou en formant plusieurs ensembles juxtaposés de substrats disposés les uns au-dessus des autres comme dans le cas de la figure 5.

Dans ce qui précède, il a été envisagé de réaliser l'outillage de guidage de flux de phase gazeuse réactive au moyen de parois. D'autres formes de réalisation peuvent être adoptées, comme illustré par la figure 8.

Sur cette figure, il a été représenté seulement un substrat S₁ supporté par un plateau 422₁ par l'intermédiaire de plots ou cales 424₁. Le substrat S₁ est disposé avec sa face interne concave dirigée vers le bas et repose par son bord sur les cales 424₁. Un flux de phase gazeuse s'écoule dans un espace annulaire 430₁ autour du substrat S₁ et à travers le plateau 422₁ pour alimenter la face interne du substrat S₁.

Le plateau 422₁, dans sa partie située en regard de la face interne du substrat S₁, présente une pluralité de passages, ou perforations 423₁ et supporte un outillage de guidage 432₁.

L'outillage 432₁ est un bloc, par exemple en graphite, ayant une forme semblable et complémentaire à celle du volume interne du substrat S₁, mais de dimension plus faible afin de ménager un espace entre la face externe du bloc et la face interne du substrat. Le bloc est percé d'une multitude de passages 433₁ qui amène la phase gazeuse traversant le plateau 422₁ jusqu'au voisinage de la face interne du substrat, de sorte que cette face interne soit parcourue par le flux de phase gazeuse sans laisser de volumes morts.

Bien que l'on ait décrit ci-avant des modes de réalisation avec une circulation générale de la phase gazeuse du bas vers le haut de l'enceinte, une disposition inversée pourra être adoptée, avec circulation de la phase gazeuse du haut vers le bas, la zone de préchauffage étant alors disposée dans la partie supérieure de l'enceinte.

En outre, le procédé selon l'invention peut bien entendu être mis en oeuvre sur des substrats de dimensions différentes logés simultanément dans l'enceinte.

### Exemple

Des substrats constitués par des préformes de bol ont été densifiés au moyen d'une installation telle que montrée par la figure 7. Les substrats étaient formés de strates bidimensionnelles en fibres de carbone drapées sur une forme et consolidées par imprégnation par une résine suivie de polymérisation et carbonisation de la résine.

La densification des substrats par une matrice de carbone pyrolytique a été réalisée en admettant dans l'enceinte une phase gazeuse comprenant du gaz naturel, ou méthane, en tant que précurseur gazeux du carbone pyrolytique.

La température et la pression dans l'enceinte ont été maintenues sensiblement constantes pendant le processus de densification, à des valeurs égales à environ 1000°C et 1,5 kPa.

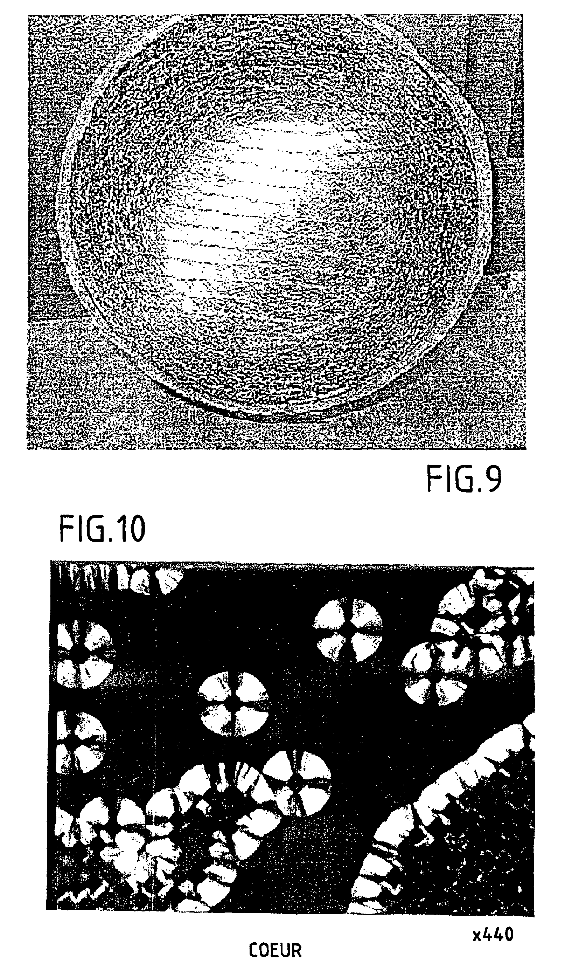

En fin de densification, aucune excroissance ou formation de suie n'a été notée. La face interne des bols en matériau composite C/C obtenus présente un bel aspect, comme le montre les figures 9 et 10, la figure 10 étant une image obtenue en microscopie optique, avec grossissement 440, d'une fraction de surface du fond d'un bol après densification.

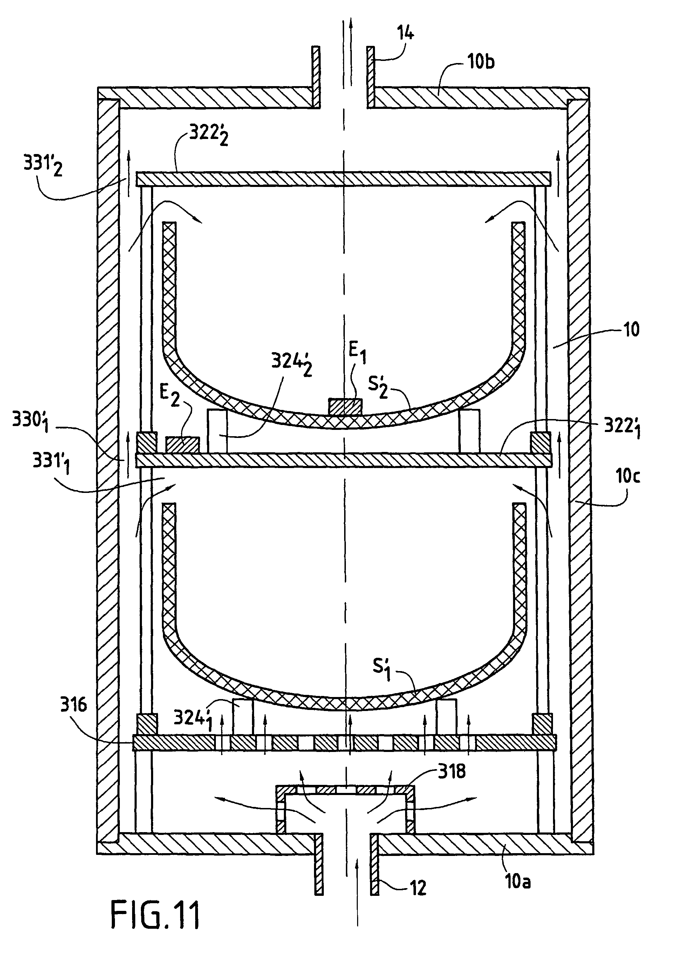

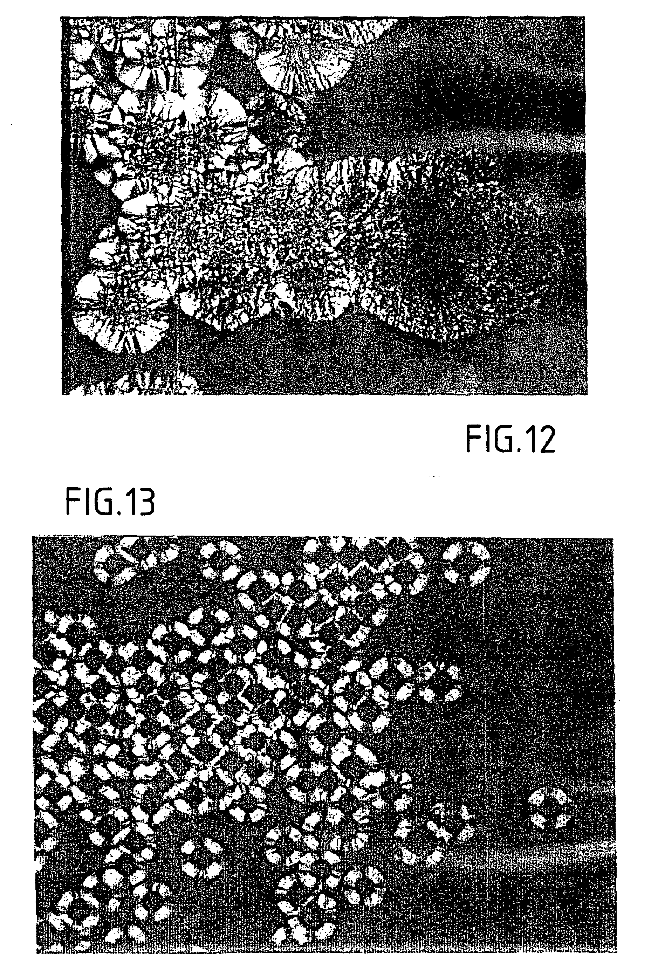

A titre comparatif, le même processus de densification a été réalisé sur des préformes similaires, mais en omettant les parois de guidage de flux 332₁ et 332₂ et les ouvertures centrales 328₁ et 328₂ des plateaux 322₁ et 322₂, comme montré sur la figure 11. Les substrats S'₁ et S'₂ reposent sur le plateau de préchauffage 316 et sur un plateau plein 332'₁ par l'intermédiaire de cales 324'₁, 324'₂ analogues aux cales 324₁, 324₂ de la figure 7. Des échantillons E₁, E₂ en un même matériau que celui des substrats sont placés respectivement au fond du substrat S'₂ et à côté de celui-ci, sur le plateau 322₁. Les figures 12 et 13 sont des images obtenues en microscopie optique avec grossissement 440, en lumière polarisée, à la surface des échantillons E₁, E₂, après densification. La présence de nombreuses excroissances et suies, à la surface de l'échantillon E₁ est manifeste, en dépit de l'amélioration apportée par la présence des plateaux par rapport à une situation où les substrats sont placés sans précaution particulière sur des supports quelconque. En effet, les plateaux, bien que ne présentant pas d'ouverture centrale et ne supportant pas d'outillage de guidage de flux réalisent tout de même une répartition du flux de phase gazeuse par les espaces 330'₁, 330'₂ et 331'₂.

En comparaison, les figures 10 et 13 ne révèlent pas d'excroissances et suies telles que celles visibles sur la figure 12, confirment que le procédé conforme à l'invention permet d'obtenir, au fond de parties creuses de substrat, une même qualité que sur des substrats ne présentant pas de parties creuses.

## Revendications

1. Procédé de densification par infiltration chimique en phase vapeur en mode isobare de substrats poreux de forme creuse ayant une face interne concave qui délimite un volume intérieur s'ouvrant par une ouverture opposée à un fond et qui est exempte de trous excepté le caractère poreux du substrat, le procédé comprenant la disposition d'au moins un substrat dans une enceinte et l'admission dans l'enceinte d'une phase gazeuse réactive,
**caractérisé en ce que**, pour le ou chaque substrat, un flux de phase gazeuse réactive admise dans l'enceinte est amené à l'emplacement du substrat et, pour une partie, est guidé par un outillage autre qu'un substrat, pénétrant dans le volume intérieur du substrat à travers l'ouverture de celui-ci et s'ouvrant vers le fond de sorte que la face interne concave du substrat est en totalité parcourue par une fraction du flux total de la phase gazeuse admise.

2. Procédé selon la revendication 1, **caractérisé en ce que** le flux de phase gazeuse réactive admise dans l'enceinte est réparti vers chaque face interne et externe du ou de chaque substrat disposé dans l'enceinte.

3. Procédé selon la revendication 2, **caractérisé en ce que** la fraction du flux total de phase gazeuse réactive parcourant une face du ou de chaque substrat disposé dans l'enceinte est d'au moins 5 %.

4. Procédé selon la revendication 2, **caractérisé en ce que** la fraction du flux total de phase gazeuse réactive parcourant une face du ou de chaque substrat disposé dans l'enceinte est d'au moins 10 %.

5. Procédé selon l'une quelconque des revendications 1 à 4, **caractérisé en ce que** l'on densifie simultanément plusieurs substrats disposés dans l'enceinte en étant alignés dans la direction générale d'écoulement du flux de phase gazeuse à travers l'enceinte.

6. Procédé selon l'une quelconque des revendications 1 à 5, **caractérisé en ce que** le flux de phase gazeuse est en partie guidé par une partie de paroi cylindrique jusqu'au voisinage du fond du ou de chaque substrat.

7. Procédé selon l'une quelconque des revendications 1 à 5, **caractérisé en ce que** le guidage d'une partie de flux de phase gazeuse est assuré par des passages formés à travers un corps logé à l'intérieur du volume délimité par la face interne concave du ou de chaque substrat.

8. Installation pour la densification par infiltration chimique en phase vapeur de substrats poreux de forme creuse ayant une face interne concave qui délimite un volume intérieur s'ouvrant par une ouverture opposée à un fond et qui est exempte de trous excepté le caractère poreux du substrat, l'installation comprenant une enceinte ayant une paroi latérale et une première et une deuxième paroi d'extrémité opposées l'une à l'autre, des moyens d'admission d'une phase gazeuse réactive débouchant dans l'enceinte à travers la première paroi d'extrémité, des moyens d'évacuation d'effluents gazeux s'ouvrant dans l'enceinte à travers la deuxième paroi d'extrémité, et au moins un plateau supportant un substrat à densifier,
installation **caractérisée en ce qu'**elle comprend des moyens de répartition et guidage de flux gazeux pour amener un flux de phase gazeuse réactive jusqu'à l'emplacement du substrat dans l'enceinte, un outillage autre qu'un substrat étant prévu qui pénètre dans le volume intérieur du substrat à travers l'ouverture de celui-ci et qui s'ouvre vers le fond pour guider une partie du flux de phase gazeuse amené à cet emplacement jusqu'à l'intérieur du volume intérieur du substrat afin que la face interne concave du substrat soit en totalité parcourue par une fraction du flux total de la phase gazeuse admise.

9. Installation selon la revendication 8, **caractérisée en ce que** l'outillage est constitué par une partie de paroi cylindrique pénétrant au moins en partie dans le volume intérieur du substrat.

10. Installation selon la revendication 8, **caractérisée en ce que** l'outillage est constitué par corps présentant une pluralité de passages traversants et pénétrant au moins en partie dans ledit volume du substrat.

11. Installation selon l'une quelconque des revendications 8 à 10, **caractérisée en ce que** les moyens de répartition de flux comprennent un ou plusieurs plateaux qui sont disposés transversalement dans l'enceinte et qui définissent des passages de répartition de flux formés par des ouvertures réalisées à travers les plateaux et des espaces ménagés entre les plateaux et une paroi latérale de l'enceinte.

## Claims

1. A method of densifying porous substrates of hollow shape by isobaric chemical vapor infiltration, the substrates having an internal concave face which delimits an internal volume opening through an aperture located opposite to a bottom and which has no holes therethrough except the porous nature of the substrate, the method comprising disposing at least one substrate in an enclosure and admitting a reactive gas into the enclosure,
**characterized in that**, for the or each substrate, a reactive gas flow admitted into the enclosure is brought to the location of the substrate and a fraction is guided by a tooling other than the substrate which penetrates into the inside volume of the substrate through its aperture and which opens towards the bottom so that said concave inside face of the substrate is swept in full by a fraction of the total admitted gas flow.

2. A method according to claim 1, **characterized in that** the reactive gas flow admitted into the enclosure is distributed towards each internal and external face of the or each substrate placed in the enclosure.

3. A method according to claim 2, **characterized in that** the fraction of the total reactive gas flow sweeping over a face of the or each substrate placed in the enclosure is not less than 5%.

4. A method according to claim 2, **characterized in that** the fraction of the total reactive gas flow sweeping over a face of the or each substrate placed in the enclosure is not less than 10%.

5. A method according to any one of claims 1 to 4, **characterized in that** a plurality of substrates are densified simultaneously, the substrates being placed inside the enclosure in alignment in the general flow direction of the gas through the enclosure.

6. A method according to any one of the claims 1 to 5, **characterized in that** the gas flow is guided in part by a cylindrical wall portion to the vicinity of the end wall of the or each substrate.

7. A method according to any one of claims 1 to 5, **characterized in that** the guidance of a portion of the gas flow is provided by passages formed through a body housed inside the volume defined by the concave inside face of the or each substrate.

8. An installation for densifying hollow-shaped porous substrate by chemical vapor infiltration, the substrates having an internal concave face which delimits an internal volume opening through an aperture located opposite to a bottom and which has no holes therethrough except the porous nature of the substrate, the installation comprising an enclosure having a side wall and first and second end walls opposite each other, means for admitting a reactive gas opening out into the enclosure through the first end wall, means for evacuating effluent gas opening out into the enclosure through the second end wall, and at least one tray supporting a substrate to be densified, the installation being **characterized in that** it further comprises means for distributing and guiding a gas flow so as to bring a reactive gas flow to the location of the substrate within the enclosure, a tooling other than the substrate being provided which penetrates into the substrate through the aperture thereof and which opens towards the bottom so as to guide a portion of the gas flow brought to said location to the inside of the inside volume of the substrate so that the concave inside face of the substrate is swept in full by a fraction of the total admitted gas flow.

9. An installation according to claim 8, **characterized in that** the tooling is constituted by a cylindrical wall portion penetrating at least in part into the inside volume of the substrate.

10. An installation according to claim 8, **characterized in that** the tooling is constituted by a body presenting a plurality of through passages and penetrating at least in part into said substrate volume.

11. An installation according to any one of claims 8 to 10, **characterized in that** the flow distribution means comprise one or more trays which are disposed transversely inside the enclosure and which define flow-distributing passages formed by openings made through the trays and by gaps left between the trays and a side wall of the enclosure.

## Patentansprüche

1. Verfahren zur Verdichtung mittels chemischer isobarer Gasphaseninfiltration von porösen Substraten hohler Form mit einer konkaven Innenseite, die einen Innenraum begrenzt, der sich über eine einem Boden gegenüberliegende Öffnung öffnet, und die bis auf den porösen Charakter des Substrats keine Löcher aufweist, wobei das Verfahren das Anordnen wenigstens eines Substrats in einer Kammer und das Einleiten einer reaktiven Gasphase in die Kammer umfaßt,
**dadurch gekennzeichnet, daß** für das oder jedes Substrat ein Strom einer in die Kammer eingeleiteten reaktiven Gasphase an den Ort des Substrats geleitet wird und zu einem Teil über eine andere Vorrichtung als ein Substrat geführt wird, die in den Innenraum des Substrats durch dessen Öffnung eindringt und sich in Richtung des Bodens öffnet, so daß die konkave Innenseite des Substrats von einem Bruchteil des Gesamtstroms der eingeleiteten Gasphase vollständig umströmt wird.

2. Verfahren nach Anspruch 1, **dadurch gekennzeichnet, daß** der Strom der in die Kammer eingeleiteten reaktiven Gasphase in Richtung einer jeden Innen- und Außenseite des oder jedes in der Kammer angeordneten Substrats verteilt wird.

3. Verfahren nach Anspruch 2, **dadurch gekennzeichnet, daß** der Bruchteil des Gesamtstroms der reaktiven Gasphase, der eine Seite des oder jedes in der Kammer angeordneten Substrats umströmt, wenigstens 5 % beträgt.

4. Verfahren nach Anspruch 2, **dadurch gekennzeichnet, daß** der Bruchteil des Gesamtstroms der reaktiven Gasphase, der eine Seite des oder jedes in der Kammer angeordneten Substrats umströmt, wenigstens 10 % beträgt.

5. Verfahren nach einem der Ansprüche 1 bis 4, **dadurch gekennzeichnet, daß** mehrere Substrate, die in der Kammer angeordnet und dabei in der allgemeinen Strömungsrichtung des Gasphasenstroms durch die Kammer ausgerichtet sind, gleichzeitig verdichtet werden.

6. Verfahren nach einem der Ansprüche 1 bis 5, **dadurch gekennzeichnet, daß** der Gasphasenstrom teilweise über einen zylindrischen Wandteil bis in die Nähe des Bodens des oder jedes Substrats geführt wird.

7. Verfahren nach einem der Ansprüche 1 bis 5, **dadurch gekennzeichnet, daß** das Führen eines Teils des Gasphasenstroms über Durchlässe sichergestellt wird, die durch einen Körper hindurch ausgebildet sind, der innerhalb des durch die konkave Innenseite des oder jedes Substrats begrenzten Raumes angeordnet ist.

8. Einrichtung für die Verdichtung mittels chemischer Gasphaseninfiltration von porösen Substraten hohler Form mit einer konkaven Innenseite, die einen Innenraum begrenzt, der sich über eine einem Boden gegenüberliegende Öffnung öffnet, und die bis auf den porösen Charakter des Substrats keine Löcher aufweist, wobei die Einrichtung eine Kammer, die eine Seitenwand sowie eine erste und eine zweite endseitige Wand, welche einander gegenüberliegen, aufweist, Mittel zum Einleiten einer reaktiven Gasphase, die durch die erste endseitige Wand in die Kammer münden, Mittel zum Abführen gasförmiger Ableitungen, die sich durch die zweite endseitige Wand in die Kammer öffnen, sowie wenigstens eine ein zu verdichtendes Substrat tragende Platte umfaßt,
Einrichtung, die **dadurch gekennzeichnet ist, daß** sie Mittel zum Verteilen und Führen von Gasströmen umfaßt, um einen Strom einer reaktiven Gasphase bis zum Ort des Substrats in der Kammer zu führen, wobei eine andere Vorrichtung als ein Substrat vorgesehen ist, die in den Innenraum des Substrats durch dessen Öffnung eindringt und sich in Richtung des Bodens öffnet, um einen Teil des diesem Ort zugeführten Gasphasenstroms bis in den Innenraum des Substrats hinein zu führen, damit die konkave Innenseite des Substrats von einem Bruchteil des Gesamtstroms der eingeleiteten Gasphase vollständig umströmt wird.

9. Einrichtung nach Anspruch 8, **dadurch gekennzeichnet, daß** die Vorrichtung von einem zylindrischen Wandteil gebildet ist, der wenigstens teilweise in den Innenraum des Substrats eindringt.

10. Einrichtung nach Anspruch 8, **dadurch gekennzeichnet, daß** die Vorrichtung von einem Körper gebildet ist, der eine Vielzahl von durchgehenden und wenigstens teilweise in den Raum des Substrats eindringenden Durchlässen aufweist.

11. Einrichtung nach einem der Ansprüche 8 bis 10, **dadurch gekennzeichnet, daß** die Mittel zum Verteilen des Stroms eine oder mehrere Platte(n) umfassen, die quer in der Kammer angeordnet sind und die Durchlässe zum Verteilen des Stroms definieren, die von durch die Platten hindurch ausgebildeten Öffnungen und von zwischen den Platten und einer Seitenwand der Kammer ausgebildeten Zwischenräumen gebildet sind.
